# EUROPÄISCHE PATENTSCHRIFT

(11) **EP 3 490 017 B1**
(45) Veröffentlichungstag und Bekanntmachung des Hinweises auf die Patenterteilung: **02.04.2025**
(21) Anmeldenummer: 17203689.9
(22) Anmeldetag: 27.11.2017
(51) Int. Cl.: H10N 30/50, H02N 2/04, F15B 21/06

(54) **AKTOREINRICHTUNG MIT FESTKÖRPERAKTOR UND HYDRAULIKEINHEIT UND EIN BETRIEBSVERFAHREN**
AN ACTUATOR COMPRISING A SOLID-STATE ACTUATOR AND A HYDRAULIC UNIT AND AN OPERATING PROCESS
DISPOSITIF D'ACTIONNEMENT POURVU D'ACTIONNEUR À ÉTAT SOLIDE FIXE ET D'UNITÉ HYDRAULIQUE ET UN PROCÉDÉ D'OPÉRATION

(43) Veröffentlichungstag der Anmeldung: 29.05.2019
(73) Patentinhaber: MetisMotion GmbH, 81549 München (DE)
(72) Erfinder: Bachmaier, Georg, 80469 München (DE); Gerlich, Matthias, 80636 München (DE); Zöls, Wolfgang, 81249 München-Lochhausen (DE)
(74) Vertreter: Hofstetter, Schurack & Partner

(56) Entgegenhaltungen:
- EP-A1- 0 886 064
- EP-A2- 1 004 783
- CN-A- 104 343 928
- DE-C1- 19 854 348
- US-A- 5 063 542
- US-A1- 2015 345 519

## Beschreibung

Die vorliegende Erfindung betrifft eine Aktoreinrichtung mit einem Festkörperaktor und einer zu dem Festkörperaktor mechanisch in Serie geschalteten Hydraulikeinheit. Die Hydraulikeinheit weist ein Hydraulikvolumen auf, welches mit einer Hydraulikflüssigkeit befüllt ist. Weiterhin betrifft die Erfindung ein Verfahren zum Betrieb einer derartigen Aktoreinrichtung.

Aus dem Stand der Technik sind vor allem piezohydraulische Aktoren bekannt, die typischerweise einen Piezoaktor und eine Hydraulikeinheit umfassen, wobei der Piezoaktor als Antrieb (genauer: als Pumpantrieb) für die Hydraulikeinheit wirkt. Ein wesentliches Merkmal solcher kombinierter Aktoreinrichtungen ist, dass durch das Vorliegen einer Hydraulikeinheit ein wesentlich größerer mechanischer Hub erreicht werden kann als mit dem Piezoaktor allein. Dies kann beispielsweise durch ein Übersetzungsverhältnis in der Hydraulikeinheit erreicht werden und/oder durch einen Pumpeffekt in der Hydraulikeinheit, welcher eine Summierung des Effekts von zahlreichen kleinen Einzelbewegungen des Piezoaktors bewirkt. Hierdurch wird ein Hauptnachteil des Piezoaktors und auch anderer bekannter Festkörperaktoren überwunden, nämlich deren geringer Hub.

Die aus dem Stand der Technik bekannten piezohydraulischen Aktoreinheiten werden typischerweise mit einem Silikonöl oder einem Glykol als Hydraulikflüssigkeit in der Hydraulikeinheit betrieben. Ein Nachteil dieser bekannten Aktoreinheiten ist, dass die verwendeten Hydraulikflüssigkeiten nicht völlig inkompressibel sind. Mit anderen Worten verändert sich das Flüssigkeitsvolumen bei variierendem Druck, was zu mechanischen Verlusten in der Hydraulikeinheit führt, denn es geht ein Teil der Energie aus der Auslenkung des Festkörperaktors in der Kompression der Hydraulikflüssigkeit verloren. Durch diesen Effekt wird der Wirkungsgrad der Aktoreinrichtung verringert. Ein weiterer Nachteil der bekannten Aktoreinheiten ist durch das thermische Verhalten von deren Hydraulikflüssigkeiten bedingt. Die relativ hohen thermischen Expansionskoeffizienten dieser Flüssigkeiten führen dazu, dass es bei Temperaturschwankungen leicht zu einer deutlichen Änderung des Zustands der gesamten Aktoreinrichtung kommt, also insbesondere zur Positionsänderung eines äußeren, durch die Aktoreinrichtung zu bewegenden Elements. Eine solche durch eine Temperaturänderung ausgelöste Zustandsänderung ist jedoch allgemein unerwünscht. Selbst bei relativ geringen Flüssigkeitsmengen führen beide Effekte zu einem unerwünschten Verhalten des Gesamtsystems.

Der EP 0 886 064 A1 ist ein Verfahren zur Einspritzung von Kraftstoff in den Verbrennungsraum der Zylinder einer Brennkraftmaschine mittels Kraftstoffinjektoren als bekannt zu entnehmen. Dabei weist ein Kraftstoffinjektor ein Injektorgehäuse, eine Düsennadel und einen über ein Steuergerät steuerbaren Piezoaktor auf. Der Piezoaktor wirkt direkt auf die Düsennadel. Dabei ist es vorgesehen, dass der Hub des Piezoaktors durch eine hydraulische Übersetzung zwischen dem Piezoaktor und der Düsennadel vergrößert wird, wobei bei der hydraulischen Übersetzung ein inkompressibles Medium als hydraulische Flüssigkeit verwendet wird.

Des Weiteren offenbart die US 2015/0345519 A1 einen magnetohydrodynamischen Aktor, welcher eine magnetohydrodonamische Pumpe, ein Expasionselement, einen Strömungskanal und flüssiges Metall aufweist.

Außerdem ist aus der CN 104 343 928 A ein hydraulisches Getriebe bekannt.

Die US 5 063 542 A offenbart einen Signal generierenden Wandler. Außerdem offenbart die DE 198 54 348 C1 eine Spindel für eine Werkzeugmaschine. Die DE19854348 offenbart eine Spindel für eine Werkzeugmaschine, insbesondere eine Hochfrequenzspindel, mit einem ersten Spannelement zum Einstellen einer Vorspannung eines in der Spindel angeordneten Lagers, insbesondere eines Schrägkugellagers, wobei das erste Spannelement mindestens einen in seiner Längsausdehnung veränderlichen Piezoaktor aufweist und in Abhängigkeit der Längsausdehnung des Piezoaktors eine veränderbare Vorspannkraft auf zumindest eine Lagerschale des Lagers ausübt. Im Kraftfluß zwischen dem ersten Spannelement und der Lagerschale ist ein Hydraulikelement angeordnet, welches eingangsseitig ein von dem ersten Spannelement beaufschlagtes Antriebsmittel und ausgangsseitig ein Abtriebsmittel aufweist, wobei der hydraulisch wirksame Querschnitt des Antriebsmittels größer ist als der hydraulisch wirksame Querschnitt des Abtriebsmittels.

Aufgabe der Erfindung ist es daher, eine Aktoreinrichtung anzugeben, welches die genannten Nachteile überwindet. Insbesondere soll eine Aktoreinrichtung zur Verfügung gestellt werden, welche geringe mechanische Verluste und geringe thermische Positionsschwankungen in der Hydraulikeinheit aufweist. Eine weitere Aufgabe ist es, ein Verfahren zum Betrieb einer derartigen Aktoreinrichtung anzugeben.

Diese Aufgaben werden durch die in Anspruch 1 beschriebene Aktoreinrichtung und das in Anspruch 7 beschriebene Verfahren gelöst. Die erfindungsgemäße Aktoreinrichtung weist einen Festkörperaktor und eine zu dem Festkörperaktor mechanisch in Serie geschaltete Hydraulikeinheit auf. Dabei weist die Hydraulikeinheit ein Hydraulikvolumen auf, welches mit einer Hydraulikflüssigkeit befüllt ist. Die Hydraulikflüssigkeit ist ein Flüssigmetall.

Unter einem Flüssigmetall soll hier allgemein ein Metall (also ein metallisches Element oder auch eine Legierung mehrerer metallische Elemente) verstanden werden, welches bei einem Betriebszustand der Aktoreinrichtung in einem flüssigen Aggregatzustand ist. Beispielsweise kann das Flüssigmetall bei Raumtemperatur und dem Betriebsdruck der Hydraulikeinheit in einem flüssigen Zustand vorliegen. Besonders vorteilhaft kann es auch noch bei tieferen Temperaturen als der Raumtemperatur oder der Betriebstemperatur der Aktoreinrichtung in einem flüssigen Zustand vorliegen, dies ist jedoch für das Funktionieren der Erfindung nicht zwingend notwendig.

Das Hydraulikvolumen kann insbesondere im Wesentlichen vollständig mit der Hydraulikflüssigkeit befüllt sein. In jedem Fall sollte Hydraulikflüssigkeit das Hydraulikvolumen so weit ausfüllen, dass durch diese Hydraulikflüssigkeit eine Übertragung mechanischer Bewegungsenergie zwischen verschiedenen Elementen der Hydraulikeinheit (insbesondere zwischen einem Antriebselement und einem Abtriebselement) ermöglicht wird.

Unter dem genannten Merkmal, dass der Festkörperaktor mit der Hydraulikeinheit "mechanisch in Serie geschaltet" ist, soll im vorliegenden Zusammenhang verstanden werden, dass Festkörperaktor und Hydraulikeinheit so verbunden sind, dass eine mechanische Bewegung eines Teils des Festkörperaktors auf einen korrespondierenden Teil der Hydraulikeinheit übertragen werden kann. Die Hydraulikeinheit ist dann insbesondere dazu ausgestaltet, diese Bewegung wiederum auf ein äußeres zu bewegendes Element zu übertragen, wobei eine solche Übertragung allgemein mit einem bestimmten Übersetzungsverhältnis und/oder mit einer Integration von mehreren Einzelbewegungen verbunden sein kann.

Ein wesentlicher Vorteil der erfindungsgemäßen Aktoreinrichtung liegt darin, dass ein Flüssigmetall allgemein im Vergleich zu herkömmlichen Hydraulikflüssigkeiten eine deutlich geringere Kompressibilität aufweist. Hierdurch werden mechanische Verluste reduziert und der Wirkungsgrad der Aktoreinrichtung im Vergleich zum Stand der Technik erhöht. Ein weiterer Vorteil der erfindungsgemäßen Aktoreinrichtung liegt darin, dass der thermischen Ausdehnungskoeffizienten eines Flüssigmetalls allgemein deutlich geringer ist als bei herkömmlichen Hydraulikflüssigkeiten. Hierdurch werden durch Temperaturschwankungen bedingte mechanische Zustandsänderungen der Hydraulikeinheit vorteilhaft reduziert. Die Viskosität und die Dichte eines Flüssigmetalls sind zwar typischerweise höher als die einer herkömmlichen Hydraulikflüssigkeit. Die damit verbundenen Nachteile können jedoch in Kauf genommen werden, um die genannten Vorteile beim Betrieb der Aktoreinrichtung zu erzielen. Insbesondere bei dem typischen relativ geringen Flüssigkeitsvolumen in der Hydraulikeinheit einer solchen Aktoreinrichtung können die eintretenden Erhöhungen von Viskosität und/oder Dichte der Hydraulikflüssigkeit gut toleriert werden.

Das erfindungsgemäße Verfahren dient zum Betrieb einer Aktoreinrichtung, wobei die Aktoreinrichtung einen Festkörperaktor und eine zu dem Festkörperaktor mechanisch in Serie geschaltete Hydraulikeinheit aufweist. Dabei weist die Hydraulikeinheit ein Hydraulikvolumen auf, welches mit einer Hydraulikflüssigkeit befüllbar ist. Die Hydraulikeinheit wird mit einem Flüssigmetall als Hydraulikflüssigkeit betrieben. Die Vorteile des erfindungsgemäßen Verfahrens ergeben sich analog zu den oben genannten Vorteilen der erfindungsgemäßen Aktoreinrichtung.

Vorteilhafte Ausgestaltungen und Weiterbildungen der Erfindung gehen aus den von den Ansprüchen 1 und 7 abhängigen Ansprüchen sowie der folgenden Beschreibung hervor. Dabei können die beschriebenen Ausgestaltungen der Aktoreinrichtung und des Betriebsverfahrens allgemein vorteilhaft miteinander kombiniert werden.

Die Hydraulikeinheit weist wenigstens eine Antriebskammer, eine Abtriebskammer und eine diese beiden Kammern verbindende erste hydraulische Leitung. Die Innenräume dieser Kammern und dieser Leitung bilden dann zumindest einen Teil des genannten Hydraulikvolumens aus. Dabei soll jedoch nicht ausgeschlossen sein, dass das Hydraulikvolumen zusätzlich noch weitere hier nicht genannte Teile, insbesondere noch weitere Kammer(n) und/oder Leitung(en) umfasst. Zusätzlich kann das Hydraulikvolumen insbesondere mit einem oder mehreren Ventilen zwischen einzelnen Bestandteilen des Volumens ausgestattet sein. Aktoreinrichtungen mit derart ausgestalteten Hydraulikeinheiten eignen sich besonders gut, um durch die jeweilige Ausgestaltung der Antriebskammer und der Abtriebskammer ein vorbestimmtes Übersetzungsverhältnis für die Hydraulikeinheit einzustellen. Somit kann beispielsweise auch bei geringem Hub des Festkörperaktors ein vergleichsweise großer Hub im Bereich der Abtriebskammer der Hydraulikeinheit erreicht werden. Mit anderen Worten lässt sich durch das Zusammenspiel zwischen Festkörperaktor und Hydraulikeinheit ein für viele Anwendungen günstiges Übersetzungsverhältnis für die Bewegung erreichen.

Die Hydraulikeinheit weist wenigstens ein die Antriebskammer teilweise begrenzendes Antriebselement auf, welches mittels des Festkörperaktors bewegbar ist. Dabei ist durch Bewegen des Antriebselements eine Strömung der Hydraulikflüssigkeit zwischen Antriebskammer und Abtriebskammer bewirkbar. Die Hydraulikeinheit kann zusätzlich wenigstens ein die Abtriebskammer teilweise begrenzendes Antriebselement aufweisen, welches wiederum durch die strömende Hydraulikflüssigkeit bewegbar ist und auf einer Ausgangsseite der Hydraulikeinheit ein äußeres zu bewegendes Element bewegen kann.

Der Festkörperaktor ist ein magnetostriktiver Aktor oder ein elektrostriktiver Aktor oder ein Piezoaktor oder ein Formgedächtnis-Aktor.

Die Hydraulikflüssigkeit ist eine eutektische Legierung. Mit einer derartigen kann ein wesentlich niedrigerer Schmelzpunkt erreicht werden kann als mit ihren einzelnen metallischen Komponenten.

Weiterhin ist es vorgesehen, dass die Hydraulikflüssigkeit bei Normaldruck bei einer Temperatur von 0 °C, insbesondere sogar bei -10 °C, flüssig ist. Mit anderen Worten ist das Flüssigmetall dann wenigstens bis hinunter zu der genannten Temperatur und unter Umständen sogar noch bei tieferen Temperaturen im flüssigen Zustand. Ein derart niedrigschmelzendes Flüssigmetall eignet sich besonders gut als Hydraulikflüssigkeit für die beschriebene Anwendung, selbst wenn die Betriebstemperatur der Aktoreinrichtung deutlich oberhalb der genannten Temperatur liegt. In jedem Fall ist bei einer derart niedrigen Schmelztemperatur die Wahl der Betriebstemperatur für die Aktoreinrichtung nicht besonders stark eingeschränkt. Für den Betrieb der Aktoreinrichtung ist es allgemein vorteilhaft, wenn die Betriebstemperatur nicht nur knapp, sondern deutlich oberhalb der Schmelztemperatur des verwendeten Flüssigmetalls liegt. Beispielsweise kann der Abstand zwischen Betriebstemperatur und Schmelztemperatur bei wenigstens 10 °C liegen. Ein solcher Sicherheitsabstand in der Temperatur wirkt sich beispielsweise auch günstig auf die Viskosität der Hydraulikflüssigkeit aus, da die Viskosität dann niedriger ist als in unmittelbarer Nähe des Schmelzpunkts.

Bei der Erfindung ist in der ersten Leitung ein erstes Einwegventil angeordnet, welches in Richtung der Abtriebskammer öffnet. Bei der Erfindung weist die Hydraulikeinheit eine die Antriebskammer mit der Abtriebskammer verbindende zweite Leitung auf, in welcher ein zweites Einwegventil angeordnet ist, welches in Richtung der Antriebskammer öffnet. Hierdurch ist auf besonders einfache Weise ein Pumpeffekt innerhalb der Hydraulikeinheit erreichbar, welcher durch den Festkörperaktor ausgelöst werden kann. Das Antriebselement vermittelt dabei die mechanische Kraftübertragung zwischen dem Festkörperaktor (da es durch diesen bewegbar ist) und den übrigen Bereichen der Hydraulikeinheit. Durch die fluidische Kopplung von Antriebskammer und Abtriebskammer mittels der hydraulischen Flüssigkeit wird erreicht, dass eine Übertragung dieser Bewegung von der Antriebskammer in die Abtriebskammer möglich ist. Abhängig von der Ausgestaltung der Kammern und der Antriebs- und Abtriebselemente kann schon bei einer einmaligen Bewegung ein Übersetzungsverhältnis ungleich 1 und insbesondere kleiner als 1 erreicht werden. Unter dem Übersetzungsverhältnis soll hier das Verhältnis von Hub auf der Antriebsseite zum Hub auf der Abtriebsseite verstanden werden. In einem solchen Fall ist also der Hub (und insbesondere auch die Geschwindigkeit) der Bewegung auf der Abtriebsseite größer als auf der Antriebsseite. Ein noch kleineres Übersetzungsverhältnis wird jedoch durch den Pumpeffekt ermöglicht: Durch die Einwegventile , die fluidisch zwischen Antriebskammer und Abtriebskammer angeordnet sind, ist für eine jeweilige Flussrichtung der Hydraulikflüssigkeit eine fluidische Sperre gegeben. Da der jeweilige Rückfluss auf diese Weise unterbunden ist, kann durch eine wiederholt ausgeführte Bewegung des Antriebselements in der Antriebskammer eine Gesamtbewegung mit größerer Amplitude für ein entsprechendes in der Abtriebskammer angeordnetes Abtriebselement erreicht werden. Über dieses Abtriebselement kann dann insgesamt eine mechanische Bewegung eines äußeren zu bewegenden Elements erreicht werden. Diese Bewegung kann durch den beschriebenen Pumpeffekt eine wesentlich höhere Amplitude aufweisen, als es durch die direkte Bewegung mittels des Festkörperaktors möglich wäre. Die für den Pumpeffekt nötige wiederholt ausgeführte Bewegung des Antriebselements wird wiederum über den Festkörperaktor vermittelt und dort beispielsweise durch ein periodisch wiederkehrendes Steuersignal mit abwechselnden ansteigenden und abfallenden Flanken ausgelöst werden.

So kann die Hydraulikflüssigkeit vorteilhaft Gallium, Indium, Zinn und/oder Quecksilber umfassen. Derartige Metalle sind vorteilhafte Komponenten, um in einer metallischen Legierung einen niedrigen Schmelzpunkt zu erreichen. Besonders vorteilhaft weist die Hydraulikflüssigkeit sowohl Gallium als auch Indium und Zinn auf. Gemäß einer besonders bevorzugten Ausführungsform besteht sie sogar ausschließlich aus den drei genannten Metallen. Beispielsweise kann es sich bei der Hydraulikflüssigkeit um eine Legierung handeln, die in der Fachwelt unter dem Namen Galinstan bekannt ist. Galinstan ist eine eutektische Legierung, welche etwa 68,5 Gewichtsprozent Gallium sowie etwa 21,5 Gewichtsprozent Indium und etwa 10 Gewichtsprozent Zinn aufweist. Eine solche Legierung weist einen sehr niedrigen Schmelzpunkt von etwa -19 °C auf. Andere geeignete niedrigschmelzende Legierungen sind beispielsweise unter den Namen Indalloy 51 und Indalloy 60 von der US-amerikanischen Firma Indium Corporation in Utica, NY erhältlich. Weitere geeignete galliumbasierte Legierungen sind beispielsweise diejenigen Legierungen, die in den Patentschriften US5800060B1 und US7726972B1 beschrieben sind. Sie können neben den drei genannten besonders bevorzugten Metallen auch Zusätze von anderen Metallen wie beispielsweise Zink (insbesondere zwischen etwa 2 und 10 Gewichtsprozent) umfassen.

Die beschriebenen Legierungen, welche auf Gallium, Indium und/oder Zinn basieren, haben den Vorteil, dass sie eine geringe Toxizität aufweisen und somit relativ unbedenklich bezüglich Gesundheits- und Umweltschädigungen sind. Quecksilber ist ebenfalls ein geeignetes Flüssigmetall oder ein geeigneter Legierungsbestandteil für niedrigschmelzende Legierungen, hat aber den grundsätzlichen Nachteil, dass es stark toxisch ist. Da das Hydraulikvolumen einer Aktoreinrichtung jedoch prinzipiell sehr gut hermetisch gegen die äußere Umgebung abgedichtet sein kann, ist auch die Verwendung von Quecksilber oder quecksilberhaltigen Legierungen prinzipiell nicht ausgeschlossen und kann für bestimmte Anwendungen ebenfalls vorteilhaft sein.

Gemäß einer allgemein bevorzugten Ausführungsform liegt das Kompressionsmodul der Hydraulikflüssigkeit oberhalb von 10 GPa, beispielsweise zwischen 20 GPa und 60 GPa. Ein derart hohes Kompressionsmodul kann durch die Verwendung eines Flüssigmetalls leicht erreicht werden und hat zur Folge, dass die mechanischen Verluste in der Hydraulikeinheit niedrig sind und dass entsprechend der Wirkungsgrad der Aktoreinrichtung hoch ist.

Gemäß einer weiteren allgemein bevorzugten Ausführungsform liegt der thermischen Ausdehnungskoeffizienten der Hydraulikflüssigkeit unterhalb von 0,001 1/K, insbesondere unterhalb von 0,00015 1/K. Ein derart niedriger thermischer Ausdehnungskoeffizient kann durch die Verwendung eines Flüssigmetalls leicht erreicht werden und hat zur Folge, dass Temperaturschwankungen beim Betrieb der Aktoreinrichtung nur geringe Positionsänderungen bei den einzelnen Elementen der Hydraulikeinrichtung zur Folge haben.

Gemäß einer weiteren allgemein bevorzugten Ausführungsform liegt die Viskosität des Flüssigmetalls oberhalb von 0,5 mm²/s, beispielsweise zwischen 1 mm²/s und 100 mm²/s. Eine derart hohe Viskosität trägt zur Verringerung von Leckagen zwischen den einzelnen Leitungsteilen und somit zur Aufrechterhaltung der nötigen Druckgefälle bei.

Gemäß einer weiteren allgemein bevorzugten Ausführungsform liegt die Dichte des Flüssigmetalls unterhalb von 8 g/cm³, beispielsweise zwischen 5 g/cm³ und 7 g/cm³. Eine derart niedrige Dichte trägt zur Verringerung der Verluste in der Hydraulikeinheit und somit zu einem guten Wirkungsgrad der Aktoreinrichtung bei.

Die hier genannten Materialparameter für das Flüssigmetall als Hydraulikflüssigkeit sollen jeweils für die Betriebsbedingungen der Aktoreinrichtung, also für deren Betriebstemperatur Betriebsdruck, gelten. Die Betriebstemperatur kann dabei insbesondere bei Raumtemperatur liegen, beziehungsweise können die Materialparameter als Parameter bei Raumtemperatur spezifiziert sein.

Das Hydraulikvolumen der Hydraulikeinrichtung, welche im Wesentlichen dem verwendeten Flüssigkeitsvolumen für das Flüssigmetall entspricht, kann allgemein bevorzugt unterhalb von 10 Millilitern liegen. Ein derart niedriges Flüssigkeitsvolumen ist allgemein vorteilhaft, um die mechanischen Verluste (insbesondere Reibungsverluste und Kompressionsverluste) der Hydraulikflüssigkeit beim Betrieb der Hydraulikeinheit möglichst gering zu halten. Dies trifft generell auch für herkömmliche Hydraulikflüssigkeiten zu. In Kombination mit den vorteilhaften Eigenschaften eines Flüssigmetalls tragen die genannten niedrigen Flüssigkeitsmengen jedoch noch umso mehr dazu bei, die Verluste und thermischen Einflüsse auf ein Minimum zu reduzieren.

Die Begrenzungswände des Hydraulikvolumens, insbesondere der Kammern und Leitung(en) der Hydraulikeinheit sind besonders vorteilhaft aus einem Material gebildet und/oder mit einem Material beschichtet, welches auch bei dauerhaftem Kontakt mit dem jeweiligen Flüssigmetall chemisch beständig ist. Viele Metalle sind korrosionsanfällig bei längerem Kontakt mit flüssigem Gallium oder galliumhaltigen Legierungen. Um die Begrenzungswände vor einer derartigen Korrosion zu schützen, können diese aus einem resistenten Material gebildet sein und/oder mit einer resistenten Schutzschicht versehen sein. Geeignete resistente Materialien sind Refraktärmetalle wie Tantal, Wolfram oder Ruthenium. Aber auch hinreichend reines Eisen oder Stahl (beispielsweise das Material, das von der Firma Carpenter Steel unter dem Namen Consumet vertrieben wird), Nickel, Titannitrid (TiN) oder diamantartige Beschichtungen können hochgradig beständig gegenüber galliumhaltigen Flüssigmetallen sein.

Allgemein bevorzugt ist die Hydraulikeinheit dazu ausgebildet, eine von dem Festkörperaktor ausgehende Bewegung mit einem Übersetzungsverhältnis von ungleich 1 auf ein äußeres zu bewegendes Element zu übertragen. Dabei soll das genannte "äußeres zu bewegendes Element" nicht Teil der Aktoreinrichtung sein. Das Übersetzungsverhältnis kann insbesondere kleiner als 1 gewählt sein, sodass der mechanische Hub auf der Austrittsseite der Hydraulikeinheit (also der mit dem zu bewegenden Element verbundenen Seite) größer ist als der Hub auf der Eintrittsseite der Hydraulikeinheit (also der mit dem Festkörperaktor verbundenen Seite). Auf diese Weise kann für die gesamte Aktoreinrichtung ein größerer Hub erzielt werden als für den einzelnen Festkörperaktor. Auf diese Weise kann der Nachteil des geringen Maximalhubs, der bei vielen solchen Aktoren vorliegt, zumindest teilweise ausgeglichen werden.

Die Hydraulikeinheit kann allgemein bevorzugt dazu ausgebildet sein, durch den Pumpeffekt eine Summierung der jeweiligen Effekte von einer Mehrzahl von Einzelbewegungen des Festkörperaktors auf ein äußeres zu bewegendes Element zu bewirken. Die Hydraulikeinheit kann also mit anderen Worten als Bewegungsintegrator ausgestaltet sein, wie weiter unten anhand eines Beispiels noch ausführlicher erläutert wird.

Die Abtriebskammer kann ein zugeordnetes Antriebselement aufweisen. Bei diesen Antriebs- und Abtriebselementen kann es sich beispielsweise Kolbenelemente oder ähnlich wirkende Elemente handeln. Die Antriebs- und Abtriebskammern können beispielsweise als Zylinder oder als Faltenbalge ausgestaltet sein.

Ein gewünschtes Übersetzungsverhältnis ist bei einer derartigen Hydraulikeinheit beispielsweise durch unterschiedliche Form und/oder Größe der jeweiligen Antriebs- und Abtriebskammern beziehungsweise durch unterschiedliche Wahl der Antriebs- und Abtriebselemente einstellbar.

Allgemein ist es aber auch möglich und unter Umständen vorteilhaft, wenn für eine einmalige Bewegung (also ohne Pumpeffekt) ein Übersetzungsverhältnis größer als 1 erreicht wird. Dies kann insbesondere dazu vorteilhaft sein, um auf der Abtriebsseite (also der Ausgangsseite des Aktors) eine besonders hohe Kraft zu erreichen. Dies ist vor allem für eine Anwendung mit einer Klemmung relevant, bei der der Aktor gegen ein festes Ende oder ein Ende mit einer sehr hohen Steifigkeit betrieben wird.

Die Hydraulikeinheit kann optional zusätzlich eine Vorratskammer für die Hydraulikflüssigkeit aufweisen. Der beschriebene Pumpeffekt kann dann insbesondere durch ein sukzessives Befüllen und oder Entleeren der Vorratskammer erreicht oder verstärkt werden. Das Vorhandensein einer solchen Vorratskammer ist jedoch nicht unbedingt notwendig, um einen derartigen Pumpeffekt zu erzielen. Vielmehr kann ein solcher Pumpeffekt auch schon durch ein Umpumpen von Hydraulikflüssigkeit zwischen Antriebskammer und Abtriebskammer allein bewirkt werden.

Piezoaktoren haben sich in der Vergangenheit als besonders vielversprechende Ausgestaltungen des Festkörperaktors in einer hydraulischen Aktoreinrichtung erwiesen. Mit ihnen kann eine besonders präzise Bewegung erreicht werden. Ihr Hauptnachteil, nämlich ihr geringer mechanischer Hub, kann wie beschrieben durch die nachfolgende Hydraulikeinheit ausgeglichen werden.

Besonders bevorzugt ist der Piezoaktor der Aktoreinrichtung als Piezostapelaktor ausgebildet. Ein Piezostapelaktor ist eine aus dem Stand der Technik grundsätzlich bekannte Serienschaltung aus mehreren einzelnen Piezoelementen, welche als Schichtstapel angeordnet sind. Ein solcher Stapelaktor ist besonders vorteilhaft, um auch schon mit den Piezoaktor eine höhere Bewegungsamplitude zu erreichen als dies mit einem einzelnen Piezoelement möglich wäre.

Die Erfindung ist jedoch nicht auf einen Piezoaktor als Festkörperaktor beschränkt. So gelten viele der bekannten Vorteile und Nachteile von Piezoaktoren auch für andere Arten von Festkörperaktoren. Auch für sie kann ein vergleichsweise geringer Ausgangs-Hub durch die nachfolgende Hydraulikeinheit vergrößert werden.

Bei dem Verfahren weist die Hydraulikeinheit wenigstens eine Antriebskammer, eine Abtriebskammer und eine diese beiden Kammern verbindende erste hydraulische Leitung auf, wobei die Hydraulikeinheit wenigstens ein die Antriebskammer teilweise begrenzendes Antriebselement aufweist, welches mittels des Festkörperaktors bewegt wird. Durch Bewegen des Antriebselements wird eine Strömung der Hydraulikflüssigkeit zwischen Antriebskammer und Abtriebskammer bewirkt. Der Festkörperaktor ist ein magnetostriktiver Aktor oder ein elektrostriktiver Aktor oder ein Piezoaktor oder ein Formgedächtnis-Aktor. Als die Hydraulikflüssigkeit wird eine eutektische Legierung verwendet wird, welche bei Normaldruck bei einer Temperatur von 0 °C flüssig ist. In der ersten Leitung ist ein erstes Einwegventil angeordnet, welches in Richtung der Abtriebskammer öffnet. Die Hydraulikeinheit weist eine die Antriebskammer mit der Abtriebskammer verbindende zweite Leitung auf, in welcher ein zweites Einwegeventil angeordnet ist, welches in Richtung der Antriebskammer öffnet

Gemäß einer bevorzugten Ausführungsvariante des Betriebsverfahrens kann der Festkörperaktor so mit einem periodisch wiederkehrenden Steuersignal aus abwechselnden ansteigenden und abfallenden Flanken betrieben werden, dass der Festkörperaktor eine oszillierende Bewegung ausführt. Diese oszillierende Bewegung ist also aus einer Vielzahl von Einzelbewegungen zusammengesetzt, die jeweils durch die einzelnen ansteigenden Flanken oder die einzelnen abfallenden Flanken das Steuersignal verursacht werden. Mittels des weiter oben beschriebenen Pumpeffekts kann durch die Hydraulikeinheit auf der Austrittsseite eine Gesamtbewegung erzeugt werden, welche einer Summierung des Effekts der jeweiligen Einzelbewegungen entspricht. Insbesondere werden durch einen solchen Pumpeffekt entweder die Effekte aller Hinbewegungen oder die Effekte aller Rückbewegungen des Festkörperaktors (und damit das Antriebselements der Hydraulikeinheit) aufsummiert. Besonders vorteilhaft werden dabei die Beiträge der jeweils anderen Richtung nicht mit summiert, wodurch sich ein Integrationseffekt ergibt.

Nachfolgend wird die Erfindung anhand zweier bevorzugter Ausführungsbeispiele unter Bezugnahme auf die angehängten Zeichnungen beschrieben, in denen:
- Figur 1: eine schematische Darstellung eines Ausführungsbeispiels einer erfindungsgemäßen Aktoreinrichtung mit Hydraulikzylindern zeigt und
- Figur 2: eine schematische Darstellung eines alternativen Ausführungsbeispiels einer erfindungsgemäßen Aktoreinrichtung mit Faltenbälgen zeigt.

In den Figuren sind gleiche oder funktionsgleiche Elemente mit gleichen Bezugszeichen versehen.

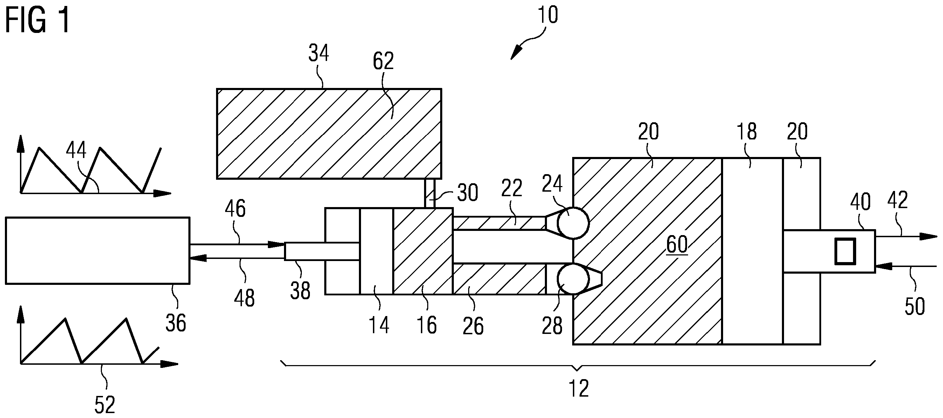

Figur 1 zeigt eine schematische Darstellung einer im Ganzen mit 10 bezeichnete Aktoreinrichtung, beispielsweise für Justieraufgaben oder als Aktor in der Robotik. Die Aktoreinrichtung 10 umfasst einen Festkörperaktor 36 und eine Hydraulikeinheit 12. Die Hydraulikeinheit 12 umfasst einen ersten Kolben 14 als Antriebselement, der in einer zugeordneten Antriebskammer 16 beweglich aufgenommen ist und einen zweiten Kolben 18 als Abtriebselement, der in einer zugeordneten Abtriebskammer 20 beweglich gelagert ist. Die Antriebskammer 16 ist über eine erste Leitung 22 mit einem Einwegventil 24, welches in Richtung der Abtriebskammer 20 öffnet, mit der Abtriebskammer 20 verbunden. Eine zweite Leitung 26 mit einem zweiten Einwegventil 28, welches in Richtung des ersten Aufnahmeraums 16 öffnet, verbindet die Abtriebskammer 20 mit der Antriebskammer 16. Die Antriebskammer 16 ist ferner über eine dritte Leitung 30, die ein Drosselelement 32 umfasst, mit einer Vorratskammer 34 für Hydraulikflüssigkeit 60 verbunden.

Zum Betätigen des Antriebselements 14 ist hier als Festkörperaktor 36 ein Piezoaktor vorgesehen. Eine vom Piezoaktor 36 auf die Kolbenstange 38 des Antriebselement 14 ausgeübte Kraft wird vom Antriebselement 14 mittels der Hydraulikflüssigkeit 60 hydraulisch auf das Antriebselement 18 übertragen, dessen Kolbenstange 40 mit einem hier nicht näher dargestellten äußeren zu bewegenden Element gekoppelt ist.

Um eine Bewegung in Richtung des Pfeils 42 zu bewirken, wird der Piezoaktor 36 gemäß dem Kraft-Zeit-Diagramm 44 angesteuert. In einer ersten Bewegungsphase wird der Piezoaktor 36 dabei schnell in Richtung des Pfeiles 46 bewegt. Die Bewegung überträgt sich auf den ersten Kolben 14, wobei der hierdurch erzeugte Druck in der Antriebskammer 16 die Schließkraft des Ventils 24 übersteigt, so dass Hydraulikflüssigkeit von der Antriebskammer 16 in die Abtriebskammer 20 übertritt und dort eine Kraft auf den zweiten Kolben 18 ausgeübt, so dass sich dieser in Richtung des Pfeils 42 bewegt. In einer zweiten Bewegungsphase wird das Piezoelement 36 in Richtung des Pfeiles 48 zurückgezogen, was jedoch deutlich langsamer erfolgt als die erste Bewegungsphase. Hierdurch bewegt sich der Kolben 14 ebenfalls in Richtung des Pfeiles 48, durch die langsame Bewegung wird jedoch die Schließkraft des Ventils 28 nicht überschritten. Es tritt also keine Hydraulikflüssigkeit aus der Abtriebskammer 20 in die Antriebskammer 16 über, der zweite Kolben 18 hält seine Position. Die Volumenänderung der Antriebskammer 16 durch die Bewegung des ersten Kolbens 14 wird durch Hydraulikflüssigkeit 60 ausgeglichen, welche aus der Vorratskammer 34 durch die Leitung 30 und Drossel 32 in die Antriebskammer 16 strömt.

Durch alternierende Wiederholung der beiden Bewegungsphasen kann somit der Kolben 18 weiter vorgeschoben werden als durch die Bewegungsreichweite des Piezoaktors 36 vorgegeben. Die Übersetzung zwischen den Kolben 14 und 18 ermöglicht dabei eine Positionierung des zweiten Kolbens 18 mit besonders hoher Präzision, wobei vorteilhafterweise zum Halten des Kolbens 18 in Position keine Kraft aufgewendet werden muss.

Soll der Kolben 18 in Gegenrichtung, also in Richtung des Pfeiles 50 zurückgezogen werden, so werden die beiden Bewegungsphasen umgekehrt, wie das Kraft-Zeit-Diagramm 52 veranschaulicht. Zunächst wird also der Piezoaktor 36 schnell in Richtung des Pfeiles 48 bewegt, so dass die resultierende Druckänderung in der Antriebskammer 16 die Schließkraft des Einwegventils 28 überschreitet und Hydraulikflüssigkeit 60 aus der Abtriebskammer 20 in die Antriebskammer 16 überströmen kann, wodurch sich der Kolben 18 in Richtung des Pfeiles 50 bewegt. In der zweiten Bewegungsphase wird der Piezoaktor 36 langsam in Richtung des Pfeiles 46 bewegt, wodurch wiederum die Schließkraft des Einwegventils 24 nicht überschritten wird, so dass der zweite Kolben 18 seine Position hält und Hydraulikflüssigkeit 60. Aus der Antriebskammer 16 über die Drossel 32 und die Leitung 30 in die Vorratskammer 34 zurückströmt. Auch hier kann durch alternierendes Wiederholen der beiden Bewegungsphasen eine weitere Bewegung des Kolbens 18 erzeugt werden.

Bei dem Beispiel der Figur 1 wird das Hydraulikvolumen 62 der Hydraulikeinheit 12 durch die Innenräume der Antriebskammer 16, der Abtriebskammer 20, der Vorratskammer 34 sowie der Leitungen 22, 26 und 30 gebildet. Dieses Hydraulikvolumen 62 ist im Wesentlichen vollständig mit der Hydraulikflüssigkeit 60 befüllt, welche hier als Flüssigmetall ausgebildet ist. Im gezeigten Beispiel handelt es sich bei dem Flüssigmetall um Galinstan. Diese Legierung weist einen sehr niedrigen Schmelzpunkt auf. Im Vergleich zu herkömmlichen Hydraulikflüssigkeiten bewirkt die Verwendung eines Flüssigmetalls, dass sowohl die Kompressionsverluste als auch thermisch induzierte Positionsänderungen auf der Austrittsseite stark reduziert sind.

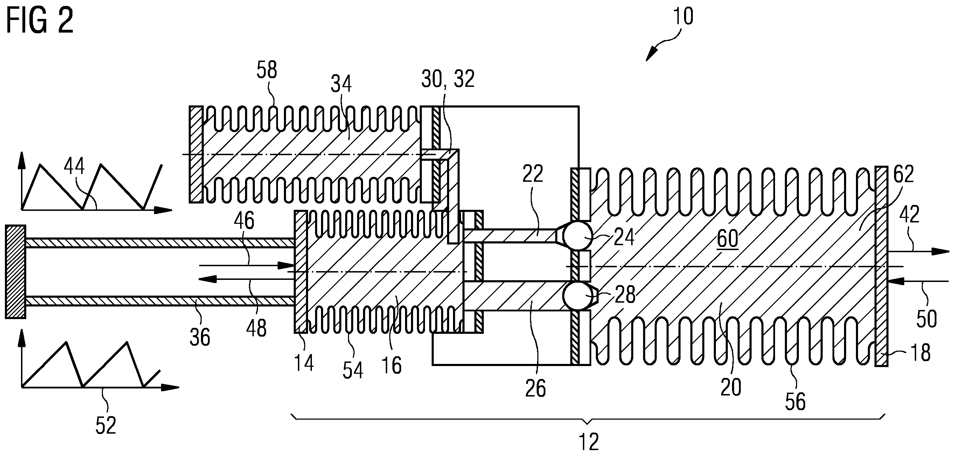

Figur 2 zeigt eine alternative Ausbildung der Vorrichtung 10, bei welcher anstelle von Hydraulikzylindern Faltenbälge 54, 56 verwendet werden, die mit den Kolbenelementen 14, 18 verbunden sind und so die Antriebskammer 16 und Abtriebskammer 20 bilden. Auch die Vorratskammer 34 wird durch einen Faltenbalg 58 gebildet. Ansonsten ist die Vorrichtung 10 gemäß Figur 2 funktionsgleich zur Vorrichtung 10 gemäß Figur 1. Die Verwendung von Faltenbälgen 54, 56, 58 ermöglicht es, die gesamte Vorrichtung 10 im Wesentlichen gekapselt auszubilden, so dass sie eine möglichst geringe Anfälligkeit für Verschmutzung und Verschleiß aufweist. Eine derartige Vorrichtung 10 kann daher besonders lange bei gleichbleibender Präzision betrieben werden. Außerdem kann eine solche besonders gut gekapselte Vorrichtung leicht auch mit korrosiven und oder toxischen Flüssigmetallen als Hydraulikflüssigkeit 60 betrieben werden.

## Patentansprüche

1. Aktoreinrichtung (10) mit einem Festkörperaktor (36) und einer zu dem Festkörperaktor (36) mechanisch in Serie geschalteten Hydraulikeinheit (12), wobei die Hydraulikeinheit (12) ein Hydraulikvolumen (62) aufweist, welches mit einer Hydraulikflüssigkeit (60) befüllt ist, wobei die Hydraulikflüssigkeit (60) ein Flüssigmetall ist, wobei die Hydraulikeinheit (12) wenigstens eine Antriebskammer (16), eine **Ab**triebskammer (20) und eine diese beiden Kammern verbindende hydraulische ersten Leitung (22) aufweist, wobei die Hydraulikeinheit (12) wenigstens ein die Antriebskammer (16) teilweise begrenzendes Antriebselement (14) aufweist, welches mittels des Festkörperaktors (36) bewegbar ist, wobei durch Bewegen des Antriebselements (14) eine Strömung der Hydraulikflüssigkeit (60) zwischen Antriebskammer (16) und Abtriebskammer (20) bewirkbar ist, und wobei der Festkörperaktor ein magnetostriktiver Aktor oder ein elektrostriktiver Aktor oder ein Piezoaktor oder ein Formgedächtnis-Aktor ist, **dadurch gekennzeichnet dass**:
- die Hydraulikflüssigkeit (60) eine eutektische Legierung ist, welche bei Normaldruck bei einer Temperatur von 0 °C flüssig ist;
- in der ersten Leitung (22) ein erstes Einwegventil (24) angeordnet ist, welches in Richtung der Abtriebskammer (20) öffnet; und
- die Hydraulikeinheit (12) eine die Antriebskammer (16) mit der Abtriebskammer (20) verbindende zweite Leitung (26) aufweist, in welcher ein zweites Einwegventil (28) angeordnet ist, welches in Richtung der Antriebskammer (16) öffnet.

2. Aktoreinrichtung (10) nach Anspruch 1, bei welcher die Hydraulikflüssigkeit (60) Gallium, Indium, Zinn und/oder Quecksilber umfasst.

3. Aktoreinrichtung (10) nach Anspruch 1 oder 2, bei welcher die Hydraulikeinheit (12) dazu ausgebildet ist, eine von dem Festkörperaktor (36) ausgehende Bewegung mit einem Übersetzungsverhältnis von ungleich eins auf ein äußeres zu bewegendes Element zu übertragen.

4. Aktoreinrichtung (10) nach einem der vorhergehenden Ansprüche, bei welcher die Hydraulikeinheit (12) dazu ausgebildet ist, durch einen Pumpeffekt eine Summierung der jeweiligen Effekte von einer Mehrzahl von Einzelbewegungen des Festkörperaktors zu bewirken.

5. Aktoreinrichtung (10) nach einem der vorhergehenden Ansprüche, bei welcher die Hydraulikeinheit (12) zusätzlich eine Vorratskammer (34) für die Hydraulikflüssigkeit (60) aufweist.

6. Aktoreinrichtung (10) nach einem der vorhergehenden Ansprüche, bei welcher der Piezoaktor als Piezostapelaktor ausgebildet ist.

7. Verfahren zum Betrieb einer Aktoreinrichtung (10), wobei die Aktoreinrichtung (10) einen Festkörperaktor (36) und eine zu dem Festkörperaktor (36) mechanisch in Serie geschalteten Hydraulikeinheit (12) aufweist, wobei die Hydraulikeinheit (12) ein Hydraulikvolumen (62) aufweist, welches mit einer Hydraulikflüssigkeit (60) befüllbar ist, wobei die Hydraulikeinheit (12) mit einem Flüssigmetall als Hydraulikflüssigkeit (60) betrieben wird, wobei die Hydraulikeinheit (12) wenigstens eine Antriebskammer (16), eine Abtriebskammer (20) und eine diese beiden Kammern verbindende hydraulische erste Leitung (22) aufweist, wobei die Hydraulikeinheit (12) wenigstens ein die Antriebskammer (16) teilweise begrenzendes Antriebselement (14) aufweist, welches mittels des Festkörperaktors (36) bewegt wird, und wobei durch Bewegen des Antriebselements (14) eine Strömung der Hydraulikflüssigkeit (60) zwischen Antriebskammer (16) und Abtriebskammer (20) bewirkt wird, und wobei der Festkörperaktor ein magnetostriktiver Aktor oder ein elektrostriktiver Aktor oder ein Piezoaktor oder ein Formgedächtnis-Aktor ist,
**dadurch gekennzeichnet, dass**:
- als die Hydraulikflüssigkeit (60) eine eutektische Legierung verwendet wird, welche bei Normaldruck bei einer Temperatur von 0 °C flüssig ist;
- in der ersten Leitung (22) ein erstes Einwegventil (24) angeordnet ist, welches in Richtung der Abtriebskammer (20) öffnet; und
- die Hydraulikeinheit (12) eine die Antriebskammer (16) mit der Abtriebskammer (20) verbindende zweite Leitung (26) aufweist, in welcher ein zweites Einwegeventil (28) angeordnet ist, welches in Richtung der Antriebskammer (16) öffnet.

8. Verfahren nach Anspruch 7,
- bei welchem der Festkörperaktor (36) so mit einem periodisch wiederkehrenden Steuersignal aus abwechselnden ansteigenden und abfallenden Flanken betrieben wird, dass der Festkörperaktor (36) eine oszillierende Bewegung ausführt, welche aus einer Vielzahl von Einzelbewegungen zusammengesetzt ist,
- und bei welchem durch die Hydraulikeinheit (12) mittels eines Pumpeffekts eine Gesamtbewegung eines äußeren zu bewegenden Elements erzeugt wird, welche einer Summierung des Effekts der jeweiligen Einzelbewegungen entspricht.

## Claims

1. An actuator device (10) comprising a solid-state actuator (36) and a hydraulic unit (12) mechanically connected in series with the solid-state actuator (36), the hydraulic unit (12) having a hydraulic volume (62) which is filled with a hydraulic fluid (60), the hydraulic fluid (60) being a liquid metal, the hydraulic unit (12) comprising at least a drive chamber (16), an output chamber (20), and a first hydraulic line (22) connecting these two chambers, the hydraulic unit (12) comprising at least one drive element (14), which partially delimits the drive chamber (16) and is movable by means of the solid-state actuator (36), a flow of the hydraulic fluid (60) between the drive chamber (16) and the output chamber (20) being able to be brought about by moving the drive element (14), and the solid-state actuator being a magnetostrictive actuator or an electrostrictive actuator or a piezo actuator or a shape-memory actuator, **characterized in that**:
- the hydraulic fluid (60) is a eutectic alloy that is liquid at normal pressure at a temperature of 0°C;
- a first one-way valve (24) is arranged in the first line (22) and opens in the direction of the output chamber (20); and
- the hydraulic unit (12) comprises a second line (26) which connects the drive chamber (16) to the output chamber (20) and in which a second one-way valve (28) is arranged, which opens in the direction of the drive chamber (16).

2. The actuator device (10) according to claim 1, in which the hydraulic fluid (60) comprises gallium, indium, tin, and/or mercury.

3. The actuator device (10) according to claim 1 or 2, in which the hydraulic unit (12) is designed to transmit a movement originating from the solid-state actuator (36) to an external element to be moved with a transmission ratio not equal to one.

4. The actuator device (10) according to any of the preceding claims, in which the hydraulic unit (12) is designed to bring about an accumulation of the respective effects of a plurality of individual movements of the solid-state actuator by means of a pumping effect.

5. The actuator device (10) according to any of the preceding claims, in which the hydraulic unit (12) additionally comprises a storage chamber (34) for the hydraulic fluid (60).

6. The actuator device (10) according to any of the preceding claims, in which the piezo actuator is designed as a piezo-stack actuator.

7. A method for operating an actuator device (10), the actuator device (10) comprising a solid-state actuator (36) and a hydraulic unit (12) mechanically connected in series with the solid-state actuator (36), the hydraulic unit (12) having a hydraulic volume (62) which can be filled with a hydraulic fluid (60), the hydraulic unit (12) being operated with a liquid metal as the hydraulic fluid (60), the hydraulic unit (12) comprising at least a drive chamber (16), an output chamber (20), and a first hydraulic line (22) connecting these two chambers, the hydraulic unit (12) comprising at least one drive element (14), which partially delimits the drive chamber (16) and is moved by means of the solid-state actuator (36), and a flow of the hydraulic fluid (60) between the drive chamber (16) and the output chamber (20) being brought about by moving the drive element (14), and the solid-state actuator being a magnetostrictive actuator or an electrostrictive actuator or a piezo actuator or a shape-memory actuator, **characterized in that**:
- a eutectic alloy that is liquid at normal pressure at a temperature of 0°C is used as the hydraulic fluid (60);
- a first one-way valve (24) is arranged in the first line (22) and opens in the direction of the output chamber (20); and
- the hydraulic unit (12) comprises a second line (26) which connects the drive chamber (16) to the output chamber (20) and in which a second one-way valve (28) is arranged, which opens in the direction of the drive chamber (16).

8. The method according to claim 7,
- in which the solid-state actuator (36) is operated with a periodically recurring control signal made up of alternating rising and falling flanks such that the solid-state actuator (36) performs an oscillating movement composed of a plurality of individual movements,
- and in which an overall movement of an external element to be moved, which corresponds to an accumulation of the effect of the respective individual movements, is generated by the hydraulic unit (12) by means of a pumping effect.

## Revendications

1. Dispositif d'actionnement (10), comprenant un actionneur à corps solide (36) et une unité hydraulique (12) connectée mécaniquement en série avec l'actionneur à corps solide (36), dans lequel l'unité hydraulique (12) présente un volume hydraulique (62) qui est rempli d'un liquide hydraulique (60), le liquide hydraulique (60) étant un métal liquide, dans lequel l'unité hydraulique (12) présente au moins une chambre d'entraînement (16), une chambre de sortie (20) et une première conduite hydraulique (22) reliant ces deux chambres, dans lequel l'unité hydraulique (12) présente au moins un élément d'entraînement (14) délimitant partiellement la chambre d'entraînement (16) et qui peut être déplacé au moyen de l'actionneur à corps solide (36), dans lequel le déplacement de l'élément d'entraînement (14) permet de provoquer un écoulement du liquide hydraulique (60) entre la chambre d'entraînement (16) et la chambre de sortie (20), et dans lequel l'actionneur à corps solide est un actionneur magnétostrictif ou un actionneur électrostrictif ou un actionneur piézoélectrique ou un actionneur à mémoire de forme,
**caractérisé en ce que** :
- le liquide hydraulique (60) est un alliage eutectique qui est liquide sous pression atmosphérique standardisée à une température de 0 °C ;
- dans la première conduite (22) est disposée une première vanne unidirectionnelle (24) qui s'ouvre en direction de la chambre de sortie (20) ; et
- l'unité hydraulique (12) présente une deuxième conduite (26) reliant la chambre d'entraînement (16) à la chambre de sortie (20) et dans laquelle est disposée une deuxième vanne unidirectionnelle (28) qui s'ouvre en direction de la chambre d'entraînement (16).

2. Dispositif d'actionnement (10) selon la revendication 1, dans lequel le liquide hydraulique (60) comprend du gallium, de l'indium, de l'étain et/ou du mercure.

3. Dispositif d'actionnement (10) selon la revendication 1 ou 2, dans lequel l'unité hydraulique (12) est réalisée pour transmettre à un élément extérieur à déplacer un mouvement partant de l'actionneur à corps solide (36) avec un rapport de transmission différent de un.

4. Dispositif d'actionnement (10) selon l'une quelconque des revendications précédentes, dans lequel l'unité hydraulique (12) est réalisée pour provoquer par un effet de pompage un cumul des effets respectifs d'une pluralité de mouvements individuels de l'actionneur à corps solide.

5. Dispositif d'actionnement (10) selon l'une quelconque des revendications précédentes, dans lequel l'unité hydraulique (12) présente de plus une réserve (34) pour le liquide hydraulique (60).

6. Dispositif d'actionnement (10) selon l'une quelconque des revendications précédentes, dans lequel l'actionneur piézoélectrique est réalisé sous forme d'actionneur à empilement piézoélectrique.

7. Procédé permettant de faire fonctionner un dispositif d'actionnement (10), dans lequel le dispositif d'actionnement (10) présente un actionneur à corps solide (36) et une unité hydraulique (12) connectée mécaniquement en série avec l'actionneur à corps solide (36), dans lequel l'unité hydraulique (12) présente un volume hydraulique (62) qui peut être rempli d'un liquide hydraulique (60), dans lequel l'unité hydraulique (12) est actionnée avec un métal liquide comme liquide hydraulique (60), dans lequel l'unité hydraulique (12) présente au moins une chambre d'entraînement (16), une chambre de sortie (20) et une première conduite hydraulique (22) reliant ces deux chambres, dans lequel l'unité hydraulique (12) présente au moins un élément d'entraînement (14) délimitant partiellement la chambre d'entraînement (16) et qui est déplacé au moyen de l'actionneur à corps solide (36), et dans lequel le déplacement de l'élément d'entraînement (14) provoque un écoulement du liquide hydraulique (60) entre la chambre d'entraînement (16) et la chambre de sortie (20), et dans lequel l'actionneur à corps solide est un actionneur magnétostrictif ou un actionneur électrostrictif ou un actionneur piézoélectrique ou un actionneur à mémoire de forme,
**caractérisé en ce que** :
- comme liquide hydraulique (60), on utilise un alliage eutectique qui est liquide sous pression atmosphérique standardisée à une température de 0 °C ;
- dans la première conduite (22) est disposée une première vanne unidirectionnelle (24) qui s'ouvre en direction de la chambre de sortie (20) ; et
- l'unité hydraulique (12) présente une deuxième conduite (26) reliant la chambre d'entraînement (16) à la chambre de sortie (20) et dans laquelle est disposée une deuxième vanne unidirectionnelle (28) qui s'ouvre en direction de la chambre d'entraînement (16).

8. Procédé selon la revendication 7,
- dans lequel l'actionneur à corps solide (36) fonctionne avec un signal de commande périodiquement récurrent, composé de flancs montants et de flancs descendants en alternance, de telle sorte que l'actionneur à corps solide (36) effectue un mouvement oscillant qui est composé d'une pluralité de mouvements individuels,
- et dans lequel l'unité hydraulique (12) produit au moyen d'un effet de pompage un mouvement global d'un élément extérieur à déplacer qui correspond à un cumul de l'effet des mouvements individuels respectifs.
